## Europäisches Patentamt

## European Patent Office

## Office européen des brevets

(19)

(11) Numéro de publication: **0 112 200**
**B1**

(12) **FASCICULE DE BREVET EUROPEEN**

(45) Date de publication du fascicule du brevet:
**04.12.85**

(51) Int. Cl.⁴: **G 01 R 27/20**

(21) Numéro de dépôt: **83402180.0**

(22) Date de dépôt: **10.11.83**

(54) Accessoire pouvant être connecté à un multimètre pour la mesure de résistances de terre.

(30) Priorité: **10.11.82 FR 8218860**

(43) Date de publication de la demande:
**27.06.84 Bulletin 84/26**

(45) Mention de la délivrance du brevet:
**04.12.85 Bulletin 85/49**

(84) Etats contractants désignés:
**AT DE GB IT**

(56) Documents cités:
**MESSEN UND PRÜFEN, no. 5, mai 1980, pages 306-308, Woerishofen, DE, U. OPPELT: "Ein Erdungsmessgerät mit elektronischem Verstärker"**
**RADIOMENTOR ELECTRONIC, vol. 44, février 1978, pages 70-71, Munich, DE, "Metrix meint Multimeter"**
**HEWLETT-PACKARD JOURNAL, vol. 28, no. 1, septembre 1976, pages 9-15, Palo Alto, US, S. HASHIMOTO et al.: "An automatic wide-range digital LCR meter"**
**BBC-NACHRICHTEN, vol. 54, septembre/octobre 1972, pages 241-252, Mannheim, DE, K.O. HOFFMANN: "Wirkungsweise und Einsatz von digitalen Messgeräten"**
**ELEKTRONIK, vol. 18, no. 5, mei 1969, pages 135-137, Munich, DE, K.H. KRÄMER et al.: "Ein handliches digitales Vielfachmessgerät"**

(73) Titulaire: **CHAUVIN ARNOUX Société dite:, 190, rue Championnet, F-75018 Paris (FR)**

(72) Inventeur: **Arnoux, Daniel, 10bis, rue d'Alsace, F-78100 St. Germain en Laye (FR)**
Inventeur: **Genter, Claude, 5, rue du Square Carpeaux, F-75018 Paris (FR)**
Inventeur: **Bousquet, Jean, 16, Allée du Chemin vert Ombreval, F-95330 Domont (FR)**

(74) Mandataire: **Lefebure, Gérard et al, Office Blétry 2, boulevard de Strasbourg, F-75010 Paris (FR)**

**0 112 200**

## Description

La présente invention concerne un accessoire pouvant être connecté à un multimètre pour la mesure de résistances de terre, du type comprenant un boîtier comportant un premier groupe de bornes pour un signal de mesure et un second groupe de bornes pour le raccordement électrique de l'accessoire au multimètre, et des circuits électriques logés dans le boîtier et connectés électriquement aux bornes des premier et second groupes de bornes.

La mise à la terre des masses des appareils électriques industriels ou ménagers est exigée par les réglements destinés à assurer la sécurité des usagers de ces appareils.

L'efficacité de ces mises à la terre est considérée comme satisfaisante si la tension à laquelle se trouvent portées les parties métalliques accessibles (masse) ne dépasse pas un certain seuil $U_S$ (généralement fixé à 24 V) en cas de défaut de l'installation. Les courants de défaut étant limités eux-mêmes par la valeur du courant de déclenchement $I_d$ des appareillages de protection, il apparaît que l'efficacité d'une mise à la terre sera liée au non dépassement d'une valeur de résistance définie par le quotient $U_s/I_d$.

Il est donc nécessaire, pour satisfaire aux prescriptions des réglements de sécurité, d'effectuer la mesure de la résistance des prises de terre non seulement lors de leur installation initiale, mais aussi ultérieurement pour s'assurer de la conservation de leur qualité.

Cette mesure exige toutefois, pour être significative, d'être effectuée suivant une procédure appropriée:

1) Utiliser un courant alternatif pour éliminer l'effet des tensions de polarisation.
2) Choisir pour ce courant une fréquence différente de celle du secteur et de ses harmoniques.
3) Prévoir un filtrage efficace des tensions parasites alternatives et continues pour les ramener à un niveau qui ne perturbe pas la mesure.

Ces exigences ont conduit à la réalisation d'appareils spécialisés dans la mesure des résistances de terre et relativement encombrants.

On connaît par ailleurs des multimètres numériques ou analogiques auxquels peuvent être connectés divers accessoires permettant d'augmenter le nombre des calibres et/ou des fonctions du multimètre. De tels multimètres sont par exemple commercialisés par la Société Chauvin Arnoux sous la dénomination »CONPA 2010«, »CONPA 2011« et »CONPA 20011«. Avec ces multimètres, la Société Chauvin Arnoux commercialise un certain nombre d'accessoires enfichables qui, lorsqu'ils sont connectés au multimètre confèrent à celui-ci les fonctions suivantes: thermomètre, luxmètre/luminancemètre, fréquencemètre, générateur de tension ou de courant, capacimètre, sonomètre, ampèremètre pour la mesure des courants alternatifs ou continus de fortes valeurs. Toutefois, à la connaissance de la Demanderesse, il n'a encore jamais été proposé un accessoire susceptible d'être connecté à un multimètre pour permettre la mesure des résistances de terre par le multimètre.

La présente invention a donc pour but de fournir un accessoire de faible encombrement, susceptible d'être connecté à un multimètre numérique ou analogique d'usage général et comportant les circuits électriques nécessaires pour réaliser des mesures de résistance de terre à l'aide dudit multimètre.

A cet effet, l'accessoire selon la présente invention est caractérisé en ce que lesdits circuits électriques comprennent un générateur de courant alternatif d'amplitude constante et de fréquence différente de celle du secteur et de ses harmoniques, ledit générateur ayant une sortie reliée à une première et à une seconde borne du premier groupe de bornes, et un circuit détecteur synchrone ayant une entrée de signal de mesure qui est reliée à la seconde et à une troisième borne du premier groupe de bornes, et une sortie qui est reliée à une première et à une seconde borne du second groupe de bornes.

Suivant une forme préférée d'exécution de la présente invention, utilisable avec un multimètre équipé d'un connecteur multiborne, sur deux des bornes duquel est disponible la tension d'une batterie incorporée au multimètre, le boîtier de l'accessoire est lui-même équipé de façon connue d'un connecteur multiborne complémentaire de celui du multimètre. Dans ce cas, deux des bornes du connecteur du boîtier forment lesdites première et seconde bornes du second groupe de bornes, et deux autres bornes du connecteur du boîtier, correspondant aux deux bornes du connecteur du multimètre sur lesquelles est disponible la tension de la batterie, sont reliées au générateur de courant alternativ d'amplitude constante pour son alimentation en courant. Autrement dit, les circuits électriques de l'accessoire sont alimentés en courant à partir de la batterie du multimètre, ce qui fait que l'on peut se passer de prévoir une batterie à l'intérieur du boîtier de l'accessoire, contribuant ainsi à réduire l'encombrement de ce dernier et à faciliter son utilisation. Le faible encombrement de l'accessoire, qui constitue une qualité determinante de ce dernier, peut être en outre obtenu par l'emploi de circuits intégrés pour une bonne partie des composants électroniques actifs entrant dans la construction des circuits électriques de l'accessoire.

On décrira maintenant une forme préférée d'exécution de la présente invention en faisant référence aux dessins annexés sur lesquels:

La figure 1 montre en perspective, le boîtier de l'accessoire de la présente invention, ainsi que le

2

multimètre auquel il peut être connecté pour la mesure des résistances de terre.

La figure 2 est un schéma montrant les circuits électriques de l'accessoire de la présente invention.

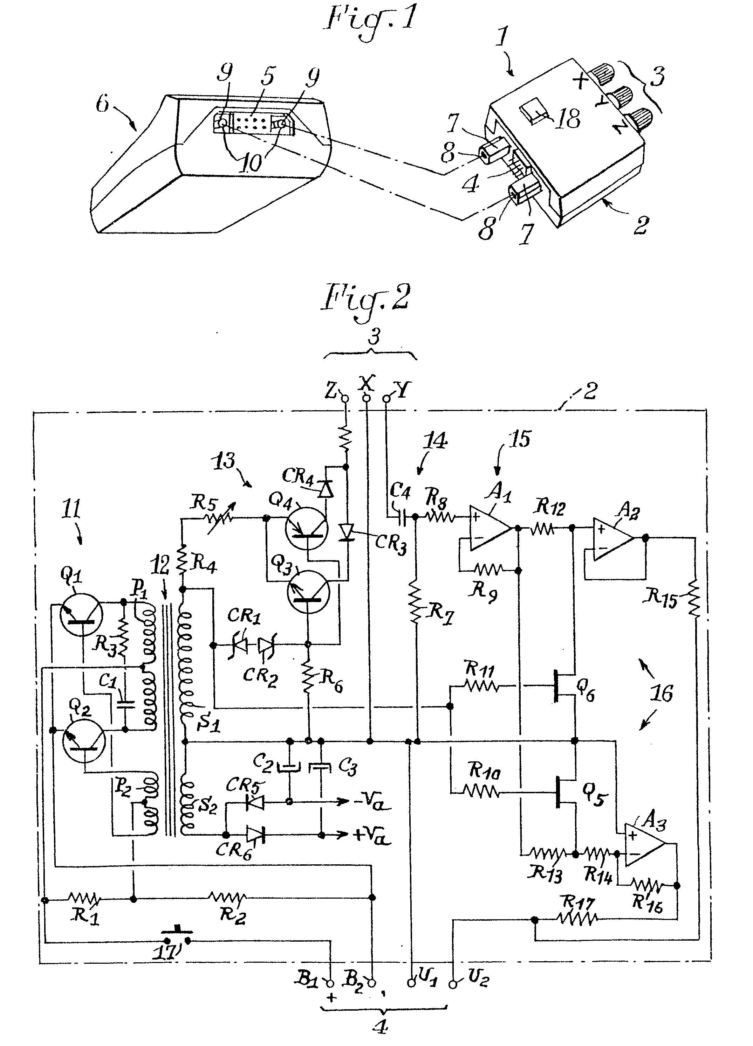

L'accessoire 1 représenté sur la figure 1 comporte un boîtier 2, de forme approximativement parallélépipédique, sur la face arrière duquel est disposé un premier groupe 3 de trois bornes X, Y et Z, et sur la face avant duquel est fixé un connecteur mâle 4 constituant un second groupe de bornes de l'accessoire 1.

La borne X est destinée à être reliée par un conducteur (non montré) à une prise de terre dont on désire mesurer la résistance. La borne Y est destinée à être reliée par un conducteur (non montré) à une prise auxiliaire de potentiel de terre de référence. La borne Z est destinée à être reliée par un conducteur (non montré) à une prise d'injection de courant dans la terre. Les trois prises susmentionnées peuvent être constituées de façon connue par des piquets de terre.

Le connecteur mâle 4 peut être enfiché dans un connecteur femelle 5 d'un multimètre 6 tel que, par exemple, un multimètre numérique modèle »CONPA 2010« ou »CONPA 2011« de la Société Chauvin Arnoux. Deux chevilles d'indexation 7, munies chacune d'un trou axial 8, font saillie sur la face avant du boîtier 2 de part et d'autre du connecteur mâle 4. Les deux chevilles 7 et leurs trous 8 peuvent être engagés respectivement dans des cavités 9, munies de broches 10, qui sont prévues dans le boîtier du multimètre 6 de part et d'autre du connecteur femelle 5. Les chevilles 7 permettent l'adaptation du boîtier 2 de l'accessoire 1 ou boîtier du multimètre 6 et en même temps, elles positionnent les broches de contact du connecteur mâle 4 par rapport aux douilles de contact du connecteur femelle 5, facilitant ainsi l'enfichage du connecteur mâle 4 dans le connecteur femelle 5 lorsqu'on monte l'accessoire 1 sur le multimètre 6.

Le multimètre contient, de façon connue, une batterie d'alimentation (non montrée) dont les bornes positive et négative sont respectivement reliées à deux des bornes ou douilles du connecteur femelle 5. Deux autres bornes ou douilles du connecteur femelle 5 servent de bornes d'entrée pour un signal de courant continu dont on désire mesurer la tension, quand le commutateur-sélecteur de calibres et de fonctions du multimètre est dans une position correspondant à une mesure de tension continue.

Dans la figure 2, on a représenté les circuits électriques de l'accessoire 1. Ce dernier comprend essentiellement, d'une part, un circuit oscillateur 11, un transformateur 12 et un régulateur de courant 13, qui forment ensemble un générateur de courant alternativ d'amplitude constante, et, d'autre part, un filtre 14, un amplificateur tampon 15 et un détecteur synchrone 16, qui traitent le signal de mesure avant qu'il soit appliqué au multimètre 6.

L'oscillateur 11 comprend deux transistors npn $Q_1$ et $Q_2$ dont les collecteurs sont connectés respectivement aux extrémités de l'enroulement primaire $P_1$ à point milieu du transformateur 12, le point milieu de l'enroulement $P_1$ étant connecté à travers un interrupteur 17 à la borne $B_1$ du connecteur mâle 4 qui est reliée par l'intermédiaire du connecteur femelle 5 à la borne positive de la batterie du multimètre 6. L'interrupteur 17 est par exemple du type à bouton poussoir 18, ce dernier étant accessible sur la face supérieure du boîtier 2 de l'accessoire 1 (figure 1). Les émetteurs des transistors $Q_1$ et $Q_2$ sont connectés directement à la borne $B_2$ du connecteur mâle 4, qui est reliée par l'intermédiaire du connecteur femelle 5 à la borne négative de la batterie du multimètre 6. Les bases des transistors $Q_1$ et $Q_2$ sont connectées respectivement aux extrémités de l'enroulement de réaction $P_2$ à point milieu du transformateur 12. Le point milieu de l'enroulement $P_2$ est connecté au point de jonction entre deux résistances $R_1$ et $R_2$ qui sont connectées en série entre les bornes $B_1$ et $B_2$ et qui forment un diviseur de tension pour la polarisation des bases des transistors $Q_1$ et $Q_2$. Un condensa-teur $C_1$ et une résistance $R_3$ sont connectés en série entre les extrémités de l'enroulement primaire $P_1$ du transformateur 12.

Les enroulements $P_1$ et $P_2$, les transistors $Q_1$ et $Q_2$, le condensateur $C_1$ et la résistance $R_3$ forment un oscillateur symétrique à relaxation d'un type connu. La fréquence d'oscillation est définie par les caractéristiques magnétiques du noyau du transformateur 12, l'inductance de l'enroulement $P_1$, la capacité du condensateur $C_1$ et la tension de la batterie d'alimentation. Les composants sont choisis de telle façon que la fréquence d'oscillation soit comprise dans la gamme de 130 à 230 Hz qui est favorable à la mesure des résistances de terre. La fréquence d'oscillation doit toutefois être choisie différente de 150 et 200 Hertz, c'est-à-dire différente des harmoniques du secteur.

Le circuit régulateur de courant 13 comprend un transistor npn $Q_3$ et un transistor pnp $Q_4$, dont les émetteurs sont connectés à travers deux résistances en série $R_4$ et $R_5$ à l'une des extrémités de l'enroulement secondaire $S_1$ du transformateur 12. Les bases des transistors $Q_3$ et $Q_4$ sont connectées d'une part à l'extrémité susmentionnée de l'enroulement secondaire $S_1$ à travers deux diodes Zener $CR_1$ et $CR_2$ montées en opposition et, d'autre part, à l'autre extrémité de l'enroulement secondaire $S_1$ à travers une résistance $R_6$. Le collecteur du transistor $Q_3$ est connecté à la cathode d'une diode $CR_3$ dont l'anode est connectée à la borne Z à travers une résistance (non désignée), tandis que le collecteur du transistor $Q_4$ est connecté à l'anode d'une diode $CR_4$ dont la cathode est connectée à la borne Z à travers ladite résistance.

Ladite autre extrémité de l'enroulement secondaire $S_1$ du transformateur 12 est connectée directement d'une part à la borne X du groupe 3 de trois bornes et, d'autre part, à la borne de sortie $U_1$ du connecteur mâle 4.

Le filtre 14 est constitué par un condensateur $C_4$ dont l'une des armatures est connectée à la borne Y du groupe 3 de trois bornes et dont l'autre armature est connectée à travers une résistance $R_7$ à la borne X. Le point de jonction entre le condensateur $C_4$ et la résistance $R_7$ est connecté à travers une résistance $R_8$ à l'entrée + d'un amplificateur opérationnel $A_1$ dont la sortie est connectée d'une part à l'entrée — de l'amplificateur $A_1$ à travers une résistance $R_9$ et, d'autre part, à l'entrée du détecteur synchrone 16.

Le détecteur synchrone 16 comprend essentiellement deux amplificateurs opérationnels $A_2$ et $A_3$ et deux transistors à effet de champ $Q_5$ et $Q_6$, respectivement à canal N et à canal P. Les transistors $Q_5$ et $Q_6$ sont commandés par le signal de courant alternatif disponible aux extrémités de l'enroulement secondaire $S_1$ du transformateur 12. A cet effet, les portes des deux transistors $Q_5$ et $Q_6$ sont connectés, respectivement à travers des résistances $R_{10}$ et $R_{11}$, au point de jonction entre la résistance $R_4$ et l'enroulement secondaire $S_1$. La sortie de l'amplificateur opérationnel $A_1$ est connectée d'une part à travers une résistance $R_{12}$ à l'entrée + de l'amplificateur opérationnel $A_2$ et, d'autre part, à travers des résistances $R_{13}$ et $R_{14}$ montées en série, à l'entrée — de l'amplificateur opérationnel $A_3$. L'entrée + de l'amplificateur opérationnel $A_2$ est connectée à la borne X à travers le trajet source-drain du transistor $Q_6$ quand celui-ci est passant. La sortie de l'amplificateur opérationnel $A_2$ est connectée d'une part directement à son entrée — et, d'autre part, à travers une résistance $R_{15}$ à la borne $U_2$ du connecteur mâle 4. L'entrée + de l'amplificateur opérationnel $A_3$ est connectée directement à la borne X, tandis que son entrée — est connectée à la borne X à travers la résistance $R_{14}$ et à travers le trajet source-drain du transistor $Q_5$ quand celui-ci est passant. La sortie de l'amplificateur opérationnel $A_3$ est connectée d'une part à travers la résistance $R_{16}$ à son entrée — et, d'autre part, à travers la résistance $R_{17}$ à la borne $U_2$.

Le transformateur 12 comporte un deuxième enroulement secondaire $S_2$ dont l'une des extrémités est connectée à l'extrémité de l'enroulement secondaire $S_1$ qui est elle-même connectée aux bornes X et $U_1$, et dont l'autre extrémité est connectée à la cathode d'une diode $CR_5$ et à l'anode d'une diode $CR_6$. Ces deux diodes fournissent, après filtrage par les condensateurs $C_2$ et $C_3$, les tensions continues $-V_a$ et $+V_a$ nécessaires au fonctionnement des amplificateurs opérationnels $A_1$, $A_2$ et $A_3$.

Avec l'accessoire 1 qui a été décrit ci-dessus, le courant alternatif qui est injecté par la borne Z dans la terre dont on désire mesurer la résistance, est régulé en amplitude par les transistors $Q_3$ et $Q_4$ associés aux diodes Zener $CR_1$ et $CR_2$ et aux résistances $R_4$ et $R_5$. La résistance $R_5$ est une résistance ajustable pour permettre un réglage précis de la valeur du courant alternatif d'amplitude constante qui est injecté dans la terre par la borne Z. En effet, la valeur de ce courant détermine le rapport entre la tension de sortie et la résistance de terre à mesurer. Dans la réalisation décrite, ce rapport est de 1 mV/ohm, permettant ainsi de lire directement la valeur de la résistance en ohms sur le calibre 100 mV du multimètre et cette valeur en kohms sur le calibre 1 V du multimètre.

L'amplificateur opérationnel $A_1$ est connecté sur l'entrée + en suiveur de tension de manière à présenter une haute impédance d'entrée. Cette haute impédance d'entrée rend la mesure de la résistance de terre indépendante de la résistance de la prise auxiliaire de potentiel de terre de référence. En conséquence, comme le courant I injecté dans la terre par la borne Z a une amplitude constante et comme le rapport susmentionné entre tension de sortie et résistance à mesurer est de 1 mV/ohm, la tension RI prélevée entre les bornes X et Y constitue une mesure de la résistance R de la terre à mesurer. En outre, la haute impédance d'entrée de l'amplificateur opérationnel $A_1$ autorise des résistances de la prise auxiliaire du potentiel de terre de référence (borne Y) de plusieurs kohms, sans perturbation sensible de la mesure.

Les transistors à effet de champ $Q_5$ et $Q_6$ associés aux amplificateurs opérationnels $A_2$ et $A_3$ réalisent un redressement synchrone de la tension prise aux bornes X et Y. Les résistances $R_{15}$ et $R_{17}$ effectuent la sommation des alternances unidirectionnelles issues des amplificateurs $A_2$ et $A_3$.

L'isolement galvanique procuré par le transformateur 12 entre la batterie d'alimentation du multimètre et les bornes de sortie $U_1$ et $U_2$ permet de relier ces dernières au multimètre sans que le fonctionnement de celui-ci s'en trouve perturbé.

A titre indicatif, les composants des circuits représentés sur la figure 2 peuvent être les suivants:

$R_1 = 5{,}1$ k$\Omega$
$R_2 = 1$ k$\Omega$
$R_3 = R_{12} = R_{13} = R_{14} = 10$ k$\Omega$
$R_4 = 1{,}15$ k$\Omega$
$R_5 = 220\ \Omega$
$R_6 = 47$ k$\Omega$
$R_7 = R_8 = 470$ k$\Omega$
$R_9 = R_{10} = R_{11} = 1$ M$\Omega$
$R_{15} = R_{16} = R_{17} = 20$ k$\Omega$
$C_1 = 1$ nF
$C_2 = C_3 = 10\ \mu$F
$C_4 = 1\ \mu$F
$CR_1 = CR_2 =$ Zener 2,49 V
$CR_3 = CR_4 = CR_5 = CR_6 = $ 1N4148

$Q_1 = Q_2 = $ BD 519
$Q_3 = $ MPSA 06
$Q_4 = $ MPSA 56
$Q_5 = $ J 112
$Q_6 = $ J 176
$A_1, A_2, A_3 = $ ampli opérationnel quadruple RC 4156 DB

Il va de soi que la forme d'exécution de la présente invention qui a été décrite ci-dessus a été donnée à titre d'exemple purement indicatif et nullement limitatif, et que de nombreuses modifications peuvent être facilement apportées par l'homme de l'art sans pour autant sortir du cadre de la présente invention. C'est ainsi notamment que, dans le cas où le multimètre n'est pas équipé d'un connecteur femelle tel que le connecteur 5, sur deux des bornes duquel est disponible la tension de la batterie du multimètre, mais uniquement de bornes d'entrée classiques pour les signaux à mesurer, le boîtier 2 ne comportera pas le connecteur mâle 4 et les chevilles 7. Au lieu de cela, le boîtier 2 comportera deux bornes (les bornes de sortie $U_1$ et $U_2$) sous la forme de douilles pouvant être raccordées aux bornes d'entrée du multimètre par des conducteurs de liaison. En outre, une batterie d'alimentation devra être prévue à l'intérieur du boîtier de l'accessoire.

Il est également possible de remplacer le dispositif de redressement synchrone 16 décrit plus haut par un circuit redresseur conventionnel asynchrone. Dans ce cas, pour compenser l'absence de filtrage qui en résulte, notamment vis à vis des tensions parasites à la fréquence du secteur, il convient alors d'introduire au niveau de l'entrée de mesure Y et en amont du redresseur, un circuit filtre convenable.

**Revendications**

1. Accessoire pouvant être connecté à un multimètre pour la mesure des résistances de terre, comprenant un boîtier (2) ayant un premier groupe de bornes (3) pour un signal de mesure et un second groupe de bornes (4) pour le raccordement électrique de l'accessoire (1) au multimètre (6), et des circuits électriques (11—16) logés dans le boîtier et connectés électriquement aux bornes des premier et second groupes de bornes, caractérisé en ce que lesdits circuits électriques (11—16) comprennent un générateur de courant alternatif (11—13) d'amplitude constante et de fréquence différente de celle du secteur et de ses harmoniques, ledit générateur ayant une sortie reliée à une première borne (Z) et à une seconde borne (X) du premier groupe de bornes (3), et un circuit détecteur (16) ayant une entrée de signal de mesure qui est reliée à la seconde borne (X) et à une troisième borne (Y) du premier groupe de bornes (3), et une sortie qui est reliée à une première borne ($U_1$) et à une seconde borne ($U_2$) du second groupe de bornes (4).

2. Accessoire selon la revendication 1, pour un multimètre (6) équipé d'un connecteur multiborne (5), sur deux des bornes duquel est disponible la tension d'une batterie incorporée au multimètre, le boîtier (2) de l'accessoire (1) étant équipé d'un connecteur multiborne (4) complémentaire de celui du multimètre, caractérisé en ce que deux des bornes du connecteur (4) du boîtier (2) forment lesdites première et seconde bornes ($U_1$ et $U_2$) du second groupe de bornes (4), et en ce que deux autres bornes ($B_1$ et $B_2$) du connecteur (4) du boîtier (2), qui correspondent aux deux bornes du connecteur (5) du multimètre (6) sur lesquelles est disponible la tension de la batterie, sont reliées au générateur de courant alternatif d'amplitude constante (11—13) pour son alimentation en courant.

3. Accessoire selon la revendication 1 ou 2, caractérisé en ce que le générateur de courant alternatif d'amplitude constante (11—13) comprend un transformateur (12) ayant un enroulement primaire ($P_1$), un enroulement secondaire ($S_1$) et un enroulement de réaction ($P_2$), un circuit oscillateur (11) à transistor ($Q_1$ et $Q_2$) relié aux enroulements primaire ($P_1$) et de réaction ($P_2$) du transformateur (12) pour produire une tension alternative aux extrémités de l'enroulement secondaire ($S_1$), et un circuit régulateur de courant alternatif (13) monté entre une première extrémité de l'enroulement secondaire ($S_1$) et ladite première borne (Z) du premier groupe de bornes (3), la seconde extrémité de l'enroulement secondaire ($S_1$) étant reliée directement à ladite seconde borne (X) du premier groupe de bornes (3).

4. Accessoire selon l'une quelconque des revendications 1 à 3, caractérisé en ce que lesdits circuits électriques (11—16) comprennent un filtre (14) et un amplificateur tampon (15) connectés en cascade l'entrée dudit filtre étant connecté aux dites seconde et troisième bornes (X, Y) du premier groupe de bornes (3) et la sortie dudit amplificateur à l'entrée de signal de mesure du circuit détecteur (16).

5. Accessoire selon les revendications 3 et 4, caractérisé en ce que le circuit détecteur (16) est un détecteur synchrone ayant une entrée de commande qui est reliée audit générateur (11—13), en ce que l'amplificateur tampon (15) et le détecteur synchrone (16) comprennent des amplificateurs opérationnels ($A_1, A_2, A_3$), et en ce que le transformateur (12) comprend un autre enroulement secondaire ($S_2$), et en ce qu'un circuit redresseur ($CR_5, CR_6$) est connecté audit autre enroulement secondaire (S2) pour produire au moins une tension continue (+Va, —Va) pour l'alimentation des amplificateurs opérationnels ($A_1, A_2, A_3$).

5

## Patentansprüche

1. Mit einem Vielfachmeßgerät verbindbares Zusatzgerät zum Messen von Erdungswiderständen, wobei das Zusatzgerät ein Gehäuse (2) mit einer ersten Klemmengruppe (3) für ein Meßsignal und eine zweite Klemmengruppe (4) für den elektrischen Anschluß des Zusatzgerätes (1) an das Multimeter (6) aufweist und im Gehäuse elektrisch an die erste Klemmengruppe und an die zweite Klemmengruppe angeschlossene elektrische Kreise (11—16) untergebracht sind, dadurch gekennzeichnet, daß die elektrischen Kreise (11—16) einen Wechselstromgenerator (11—13) konstanter Amplitude und von der Netzfrequenz und ihren Harmonischen verschiedener Frequenz, wobei der Generator einen an eine erste Klemme (Z) und an eine zweite Klemme (X) der ersten Klemmengruppe (3) angeschlossenen Ausgang besitzt, weiters einen Detektorkreis (16) mit einem an die zweite Klemme (X) und eine dritte Klemme (Y) der ersten Klemmengruppe (3) angeschlossenen Eingang für das Meßsignal und weiters einen an eine erste Klemme ($U_1$) und an eine zweite Klemme ($U_2$) der zweiten Klemmengruppe (4) angeschlossenen Ausgang aufweist.

2. Zusatzgerät nach Anspruch 1 für ein Multimeter (6), welches mit einem mehrere Klemmen aufweisenden Verbindungsstück (5) ausgestattet ist, bei welchem an zwei seiner Klemmen die Spannung einer in das Multimeter eingesetzten Batterie zur Verfügung steht, wobei das Gehäuse (2) des Zusatzgerätes (1) mit einem mehrere Klemmen aufweisenden Verbindungsstück (4) ausgestattet ist, welches dem Verbindungsstück des Multimeters komplementär ist, dadurch gekennzeichnet, daß zwei der Klemmen des Verbindungsstückes (4) des Gehäuses (2) die erste Klemme und die zweite Klemme ($U_1$ und $U_2$) der zweiten Klemmengruppe (4) bilden und daß zwei andere Klemmen ($B_1$ und $B_2$) des Verbindungsstückes (4) des Gehäuses (2), welche jenen zwei Klemmen des Verbindungsstückes (5) des Multimeters (6) entsprechen, an welchen die Spannung der Batterie zur Verfügung steht, mit dem Wechselstromgenerator (11—13) konstanter Amplitude zwecks Stromversorgung desselben verbunden sind.

3. Zusatzgerät nach Anspruch 1 oder 2, dadurch gekennzeichnet, daß der amplitudenkonstante Wechelstromgenerator (11—13) einen eine Primärwicklung ($P_1$), eine Sekundärwicklung ($S_1$) und eine Reaktionswicklung ($P_2$) aufweisenden Transformator (12), einen mit Transistoren ($Q_1$ und $Q_2$) bestückten und zwecks Erzeugung einer Wechselspannung an den Enden der Sekundärwicklung ($S_1$) an die Primärwicklung ($P_1$) und an die Reaktionswicklung ($P_2$) des Transformators (12) angeschlossenen Oszillatorkreis (11) und einen zwischen einem ersten Ende der Sekundärwicklung ($S_1$) und der ersten Klemme (Z) der ersten Klemmengruppe (3) geschalteten Wechselstromregelkreis (13) aufweist, wobei das zweite Ende der Sekundärwicklung ($S_1$) direkt an die zweite Klemme (X) der ersten Klemmengruppe (3) angeschlossen ist.

4. Zusatzgerät nach irgendeinem der Ansprüche 1 bis 3, dadurch gekennzeichnet, daß die erwähnten elektrischen Schaltkreise (11—16) in Kaskadenschaltung ein Filter (14) und einen Pufferverstärker (15) aufweisen und der Eingang des Filters an die zweite Klemme und die dritte Klemme (XY) der ersten Klemmengruppe (3) und der Ausgang des Verstärkers an den Meßsignaleingang des Detektorkreises (16) angeschlossen ist.

5. Zusatzgerät nach den Ansprüchen 3 und 4, dadurch gekennzeichnet, daß der Detektor (16) ein Synchrondetektor ist, der einen an den Generator (11—13) angeschlossenen Steuereingang besitzt, daß der Pufferverstärker (15) und der Synchrondetektor (16) Operationsverstärker ($A_1$, $A_2$, $A_3$) aufweisen und daß der Transformator eine weitere Sekundärwicklung ($S_2$) aufweist und daß eine Gleichrichterschaltung ($CR_5$, $CR_6$) an die andere Sekundärwicklung ($S_2$) angeschlossen ist, um für die Versorgung der Operationsverstärker ($A_1$, $A_2$, $A_3$) zumindest eine Gleichspannung ($+Va$, $-Va$) zu erzeugen.

## Claims

1. Accessory connectable to a multimeter for the measurement of earth resistances, comprising a box (2) having a first group of terminals (3) for a measurement signal and a second group of terminals (4) for the electrical connection of the accessory (1) to the multimeter (6), as well as electrical circuits (11—16) placed in the box and electrically connected to the terminals of the first and second terminal groups, characterized in that, said electrical circuits (11—16) comprise an alternating current generator (11—13) having a constant amplitude and a frequency differing from that of the mains and its harmonics, said generator having an output connected to a first terminal (Z) and to a second terminal (X) of the first group of terminals (3), and a detector circuit (16) having a measurement signal input connected to the second terminal (X) and to a third terminal (Y) of the first group of terminals (3) and an output connected to a first terminal ($U_1$) and to a second terminal ($U_2$) of the second group of terminals (4).

2. Accessory according to Claim 1 for a multimeter (6) equipped with a multiterminal connector (5), on whose two terminals is available the voltage of a battery incorporated into the multimeter, the box (2) of accessory (1) being equipped with a multiterminal connector (4) complementary to that of the multimeter, characterized in that, two of the terminals of connector (4) of box (2) form said first and second terminals ($U_1$ and $U_2$) of the second group of terminals (4) and in that two other terminals ($B_1$ and $B_2$) of connector (4) of box (2), which correspond to the two terminals of connector (5) of multimeter (6) on which is available the voltage of the battery, are connected to the constant amplitude alternating current generator (11—13) for the power supply thereof.

3. Accessory according to Claims 1 or 2, characterized in that, the constant amplitude alternating current generator (11—13) comprises a transformer (12) having a primary winding ($P_1$), a secondary winding ($S_1$) and a reaction winding ($P_2$), an oscillator circuit (11) with transistor ($Q_1$ and $Q_2$) connected to the primary ($P_1$) and reaction ($P_2$) windings of transformer (12) for producing an alternating current voltage at the ends of the secondary winding ($S_1$) and an alternating current regulating circuit (13) fitted between a first end of the secondary winding ($S_1$) and said first terminal (2) of the first group of terminals (3), the second end of the secondary winding ($S_1$) being directly connected to the second terminal (X) of the first group of terminals (3).

4. Accessory according to any one of the Claims 1 to 3, characterized in that, said electrical circuits (11—16) comprise a filter (14) and a buffer amplifier (15) connected in cascade, the input of said filter being connected to said second and third terminals (X, Y) of the first group of terminals (3) and the output of said amplifier to the input of the measurement signal of detector circuit (16).

5. Accessory according to Claims 3 and 4, characterized in that the detector circuit (16) is a synchronous detector having a control input connected to the generator (11—13), in that the buffer amplifier (15) and the synchronous detector (16) comprise operational amplifiers ($A_1$, $A_2$, $A_3$), in that the transformer (12) comprises another secondary winding ($S_2$) and that a rectifier circuit ($CR_5$, $CR_6$) is connected to said other secondary winding ($S_2$) to produce at least one direct current voltage ($+Va$, $-Va$) for supplying the operational amplifiers ($A_1$, $A_2$, $A_3$).

## Fig.1

## Fig.2